# EUROPEAN PATENT APPLICATION

(11) **EP 2 172 987 A1**
(43) Date of publication of application: **07.04.2010**
(21) Application number: 08165797.5
(22) Date of filing: 02.10.2008
(51) Int. Cl.: H01L 51/42

(54) **Solar cell having tandem organic and inorganic structures and related system and method**

(71) Applicant: Honeywell International Inc., Morristown, NJ 07962 (US)
(72) Inventor: Dumitru, Viorel-Georgel, 100077 Ploiesti, Prahova (RO); Avramescu, Viorel, 030342 Bucharest (RO); Cobianu, Cornel, 061672 Bucharest (RO)
(74) Representative: Buckley, Guy Julian

(57) **Abstract**

A solar cell (100) includes an organic heterojunction (104) having at least one donor material (106) and at least one acceptor material (108). The solar cell also includes an inorganic heterojunction (110) having multiple inorganic semiconductor materials (112-114). The organic heterojunction and the inorganic heterojunction could absorb light in different portions of a solar spectrum. For example, the organic heterojunction could absorb higher-energy photons, and the inorganic heterojunction could absorb lower-energy photons. The inorganic heterojunction could include a p-type inorganic semiconductor material having a bandgap between one and two elect-on-volts and an n-type inorganic semiconductor material having a bandgap greater than three electron-volts. An inorganic semiconductor layer (120) could be placed between the organic heterojunction and the inorganic heterojunction. The inorganic semiconductor layer could be configured to collect holes generated by the organic heterojunction and to block electrons generated by the organic heterojunction.

## Description

### TECHNICAL FIELD

This disclosure relates generally to solar cells and more specifically to a solar cell having tandem organic and inorganic structures and related system and method.

### BACKGROUND

Various types of solar cells have been developed over the years. One type of solar cell is the donor-acceptor (DA) organic solar cell, which is formed using two different plastics or other polymers. In these types of solar cells, light absorption leads to the formation of an exciton (a bound electron-hole pair) that diffuses to a donor-acceptor heterojunction interface. This interface is formed at the contact between two organic semiconductors with different valence bands (VB) and conduction bands (CB).

The exciton dissociates at this interface into a hole and an electron. If an exciton is created in the donor material and reaches the donor/acceptor interface, the electron is transferred to the acceptor material, while the hole recedes in the donor material. Similarly, if an exciton is created in the acceptor material and reaches the donor/acceptor interface, the hole is transferred to the donor material, while the electron recedes in the acceptor material. The hole travels through the donor material to a first electrode, and the electron travels through the acceptor material to a second electrode. In this way, holes and electrons can be used to supply power to an external component coupled to the electrodes.

### SUMMARY

This disclosure provides a solar cell having tandem organic and inorganic structures and related system and method.

In a first embodiment, a solar cell includes an organic heterojunction having at least one donor material and at least one acceptor material. The solar cell also includes an inorganic heterojunction having multiple inorganic semiconductor materials.

In particular embodiments, the organic heterojunction and the inorganic heterojunction absorb light in different portions of a solar spectrum. The organic heterojunction could absorb higher-energy photons, and the inorganic heterojunction could absorb lower-energy photons. The inorganic heterojunction could include a p-type inorganic semiconductor material having a bandgap between one and two electron-volts and an n-type inorganic semiconductor material having a bandgap greater than three electron-volts.

In other particular embodiments, the solar cell also includes multiple electrodes providing electrical connection to the solar cell. A first of the electrodes could include zinc oxide doped with aluminum, and a second of the electrodes could include platinum.

In yet other particular embodiments, the solar cell also includes an inorganic semiconductor layer between the organic heterojunction and the inorganic heterojunction. The inorganic semiconductor layer is configured to collect holes generated by the organic heterojunction. The inorganic semiconductor layer could also be configured to block electrons generated by the organic heterojunction from reaching the inorganic heterojunction. The solar cell further includes a buffer layer between the organic heterojunction and the inorganic semiconductor layer, where the buffer layer improves hole injection onto the inorganic semiconductor layer. The inorganic semiconductor layer could include nickel oxide, and the buffer layer could include PEDOT.

In still other particular embodiments, the at least one donor material could include MEH-PPV, MDMO-PPV, and/or P3HT. Also, the at least one acceptor material could include CN-ether-PPV and/or PCBM. In addition, the inorganic semiconductor materials include (i) a copper oxide and/or copper indium gallium selenide and (ii) zinc oxide, titanium oxide, and/or tin oxide.

In a second embodiment, a system includes a solar cell and circuitry configured to receive power from the solar cell. The solar cell includes an organic heterojunction including at least one donor material and at least one acceptor material. The solar cell also includes an inorganic heterojunction including multiple inorganic semiconductor materials.

In a third embodiment, a method includes receiving radiation at a solar cell. The method also includes generating electrons and holes using an organic heterojunction structure in the solar cell, where the organic heterojunction structure includes at least one donor material and at least one acceptor material. The method further includes generating electrons and holes using an inorganic heterojunction structure in the solar cell, where the inorganic heterojunction structure includes multiple inorganic semiconductor materials. In addition, the method includes collecting at least some of the electrons at a first electrode and collecting at least some of the holes at a second electrode.

Other technical features may be readily apparent to one skilled in the art from the following figures, descriptions, and claims.

### BRIEF DESCRIPTION OF THE DRAWINGS

For a more complete understanding of this disclosure, reference is now made to the following description, taken in conjunction with the accompanying drawings, in which:

FIGURE 1 illustrates an example solar cell having tandem organic and inorganic structures according to this disclosure;

FIGURES 2A through 2D illustrate example energy band diagrams of a solar cell having tandem organic and inorganic structures according to this disclosure;

FIGURES 3 and 4 illustrate example techniques for forming a solar cell having tandem organic and inorganic structures according to this disclosure;

FIGURE 5 illustrates an example circuit containing a solar cell having tandem organic and inorganic structures according to this disclosure; and

FIGURE 6 illustrates an example method for using a solar cell having tandem organic and inorganic structures according to this disclosure.

### DETAILED DESCRIPTION

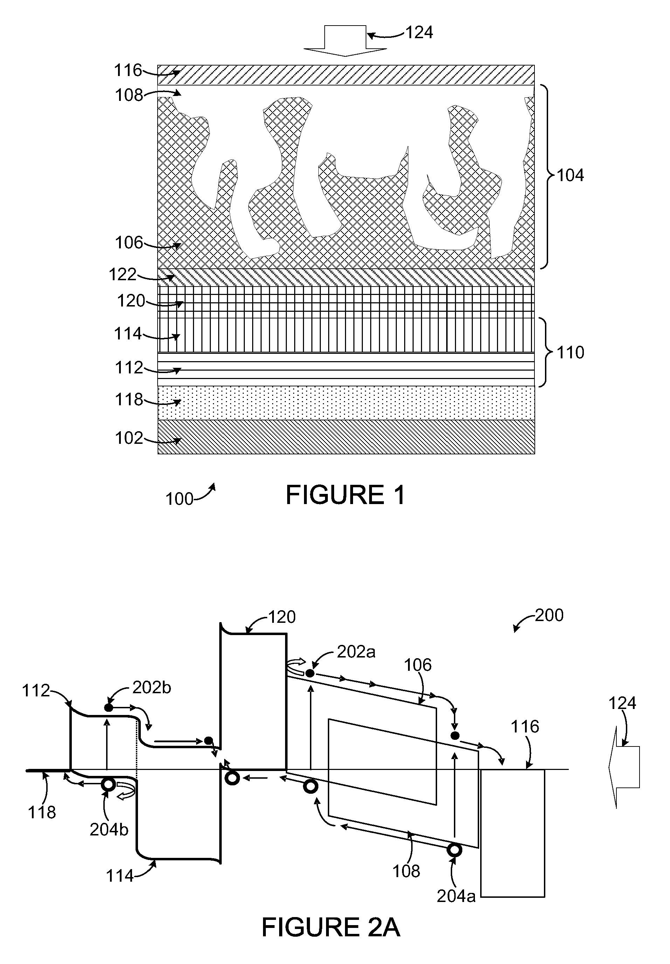

FIGURES 1 through 6, discussed below, and the various embodiments used to describe the principles of the present invention in this patent document are by way of illustration only and should not be construed in any way to limit the scope of the invention. Those skilled in the art will understand that the principles of the invention may be implemented in any type of suitably arranged device or system.

FIGURE 1 illustrates an example solar cell 100 having tandem organic and inorganic structures according to this disclosure. The embodiment of the solar cell 100 shown in FIGURE 1 is for illustration only. Other embodiments of the solar cell 100 could be used without departing from the scope of this disclosure.

As shown in FIGURE 1, the solar cell 100 includes a substrate 102. The substrate 102 represents a structure on which other components of the solar cell 100 are formed, carried, or otherwise supported. The substrate 102 represents any suitable structure for supporting other components of the solar cell 100. The substrate 102 could also be formed from any suitable material(s) and in any suitable manner. In particular embodiments, the substrate 102 represents a metal foil.

The solar cell 100 also includes an organic heterojunction 104, which includes two organic materials 106-108. The organic materials 106-108 represent donor and acceptor materials, respectively, in the solar cell 100. For example, light absorption can create excitons in one or more of the organic materials 106-108, and the excitons diffuse to the boundary of the organic materials 106-108. At the boundary, the excitons dissociate to create holes and electrons. At least some of the holes travel through the donor organic material 106, and at least some of the electrons travel through the acceptor organic material 108.

The organic material 106 represents any suitable organic material or combination of organic materials used as a donor material in a solar cell. For example, the organic material 106 could include poly(methoxy-ethylexyloxy-phenylenevinilene) (also called "MEH-PPV"), poly[2-methoxy-5-(3',7'-dimethyloctyloxy)-1,4-phenylene vinylene] (also called "MDMO-PPV"), or poly(3-hexylthiophene) (also called "P3HT"). The organic material 108 represents any suitable organic material or combination of organic materials used as an acceptor material in a solar cell. For example, the organic material 108 could include poly[oxa-1,4-phenylene-1,2-(1-cyano)-ethenylene-2,5 dioctyloxy-1,4-phenylene-1,2-(2-cyano)-ethenylene-1,4-phenylene] (also called "CN-ether-PPV") or 1-(3-methoxycarbonyl)-propyl-1-phenyl-(6,6)C₆₁ (also called "PCBM").

In this example, different organic materials 106-108 are used in the organic heterojunction 104, which is why the organic heterojunction 104 is said to have a "heterojunction" structure. Also, the organic materials 106-108 are deposited or otherwise formed having a random (non-planar) boundary, so the organic heterojunction 104 is said to have a "bulk" structure. The random nature of the boundary between the organic materials 106-108 helps to increase the area where the organic materials 106-108 contact one another.

In some embodiments, the organic heterojunction 104 has a relatively high bandgap, such as a bandgap larger than two electron-volts (eV). Because of this, the organic heterojunction 104 could be relatively transparent to photons with lower energies, meaning those photons cannot be used by the organic heterojunction 104 to generate power. To make the solar cell 100 more efficient, the solar cell 100 further includes an inorganic heterojunction 110, which includes two inorganic semiconductor layers 112-114. The inorganic semiconductor layer 112 could include one or more p-type semiconductor materials, while the inorganic semiconductor layer 114 could include one or more n-type semiconductors. Each of the inorganic semiconductor layers 112-114 could be formed in any suitable manner.

The inorganic semiconductor layer 112 in this example may represent a light absorber, such as one with a bandgap between one and two electron-volts (such as around 1.35 electron-volts or other bandgap below two electron-volts). Also, the inorganic semiconductor layer 114 could have a large bandgap, such as greater than three electron-volts. This allows the inorganic heterojunction 110 to absorb and use photons with lower energies. This can help to provide a better match for the solar spectrum and increase the efficiency of the solar cell 100. In particular embodiments, the inorganic semiconductor layer 112 could represent copper oxide (CuO), other cuprous oxide (CuₓOy), or copper indium gallium selenide (CIGS). The inorganic semiconductor layer 114 could represent zinc oxide (ZnO), titanium oxide (TiO₂), or tin oxide (SnO₂). Also, in particular embodiments, the inorganic semiconductor layer 114 could be doped so that its Fermi level is between 4.8 and 5.2 electron-volts (relative to vacuum level). However, any other or additional material(s) could be used in each of the inorganic semiconductor layers 112-114.

Two electrodes 116-118 provide an electrical connection to the solar cell 100. For example, one or more additional electrical components can be coupled to the electrodes 116-118 and powered by the solar cell 100. In this example, the electrode 116 collects electrons, and the electrode 118 collects holes. Each of the electrodes 116-118 includes any suitable material(s) providing an electrical connection. For example, the electrode 116 could be formed from an n-type transparent conducting oxide, such as zinc oxide that is doped with aluminum (with a Fermi level around 4.2 electron-volts). As another example, the electrode 118 could be formed from platinum. Also, each of the electrodes 116-118 could be formed in any suitable manner.

An inorganic semiconductor layer 120 is formed between the organic heterojunction 104 and the inorganic heterojunction 110. The inorganic semiconductor layer 120 may be used to collect holes generated by the organic heterojunction 104. These holes may then recombine with electrons generated by the inorganic heterojunction 110 at the interface between the inorganic semiconductor layer 120 and the inorganic semiconductor layer 114. The inorganic semiconductor layer 120 could also block electrons generated by the organic heterojunction 104 from passing to the inorganic heterojunction 110. The inorganic semiconductor layer 120 could be formed from any suitable material(s), such as a transparent p-type material like nickel oxide (NiO) (with a Fermi level around 4.8 electron-volts).

An optional buffer layer 122 can be formed between the organic heterojunction 104 and the inorganic semiconductor layer 120. Among other things, the buffer layer 122 could help to improve hole injection onto the layer 120. The buffer layer 122 could be formed from any suitable material(s), such as poly(3,4-ethylenedioxythiophene) poly(styrenesulfonate) (also called "PEDOT:PSS"). The buffer layer 122 could also be formed in any suitable manner.

In some embodiments, light 124 enters the solar cell 100 through the transparent electrode 116 and falls on the organic heterojunction 104. The organic heterojunction 104 can absorb photons with higher energy levels (such as more than two electron-volts), but the organic heterojunction 104 may be almost transparent to photons with lower energy levels. Based on the absorbed photons, the organic heterojunction 104 generates excitons that subsequently dissociate into holes and electrons. At least some of the remaining photons can reach the inorganic heterojunction 110 and be absorbed by the inorganic semiconductor layer 112. The inorganic heterojunction 110 could generate additional holes and electrons based on the absorbed photons. At least some of the generated electrons are collected by the electrode 116, and at least some of the generated holes are collected by the electrode 118. In this way, the solar cell 100 can provide a better coverage of the solar spectrum. Moreover, the electrode 116 (such as one formed from ZnO:Al) could absorb ultraviolet (UV) light. This can help to prevent UV radiation from reaching the polymers forming the organic heterojunction 104, which can prolong the life of the solar cell 100.

Although FIGURE 1 illustrates an example solar cell 100 having tandem organic and inorganic structures, various changes may be made to FIGURE 1. For example, the organic materials 106-108 could have any suitable boundary, and the inorganic semiconductor layers 112-114 could have any suitable boundary. Also, any number of organic and inorganic semiconductor materials could be used in the solar cell 100. In addition, while FIGURE 1 illustrates two stacked heterojunctions, the solar cell 100 could include any suitable number of organic and inorganic heterojunctions.

FIGURES 2A through 2D illustrate example energy band diagrams of a solar cell having tandem organic and inorganic structures according to this disclosure. The energy band diagrams shown in FIGURES 2A through 2D are for illustration only. A solar cell having tandem organic and inorganic structures could have any suitable energy band diagram without departing from the scope of this disclosure.

FIGURE 2A illustrates an energy band diagram 200 for a solar cell 100 where:
- the organic heterojunction 104 is formed from P3HT and PCBM;
- the inorganic heterojunction 110 is formed from copper oxide and zinc oxide or titanium oxide;
- the electrodes 116-118 are formed from ZnO:Al and platinum, respectively;
- the inorganic semiconductor layer 120 is formed from nickel oxide; and
- no buffer layer 122 is used.

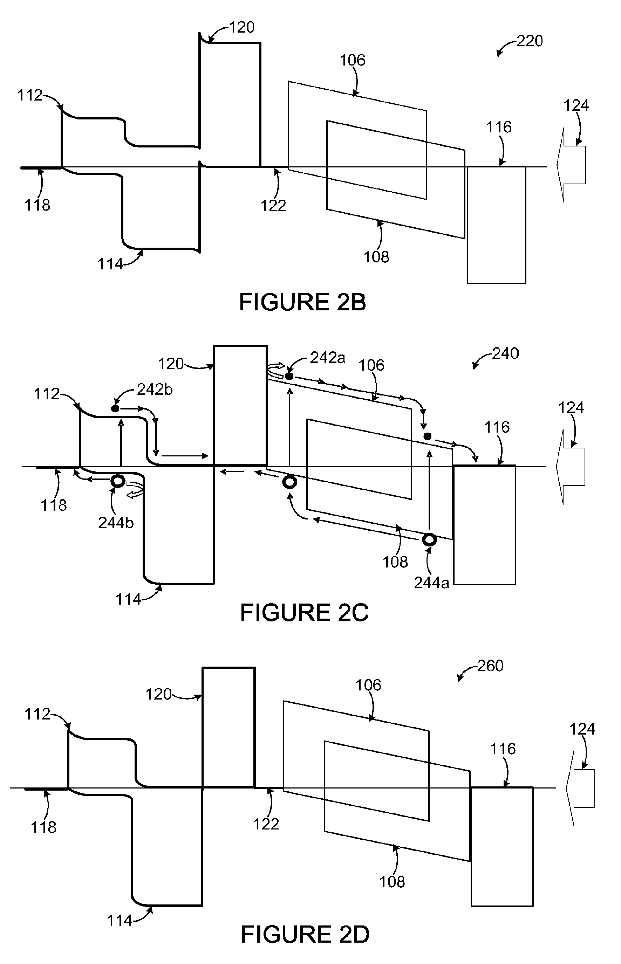

As shown here, electrons 202a formed in the organic heterojunction 104 are collected by the electrode 116. The inorganic semiconductor layer 120 acts as a blocking layer to reduce or prevent the electrons 202a from reaching the inorganic heterojunction 110. Holes 204a generated in the organic heterojunction 104 pass through the inorganic semiconductor layer 120 and can recombine with electrons 202b generated by the inorganic heterojunction 110. Holes 204b generated in the inorganic heterojunction 110 are collected by the electrode 118. FIGURE 2B illustrates an energy band diagram 220 for the same type of solar cell 100 as in FIGURE 2A, except the solar cell associated with FIGURE 2B includes a PEDOT buffer layer 122.

FIGURE 2C illustrates an energy band diagram 240 for a solar cell 100 where:
- the organic heterojunction 104 is formed from P3HT and PCBM;
- the inorganic heterojunction 110 is formed from copper oxide and tin oxide;
- the electrodes 116-118 are formed from ZnO:Al and platinum, respectively;
- the inorganic semiconductor layer 120 is formed from nickel oxide; and
- no buffer layer 122 is used.

As shown here, electrons 242a-242b and holes 244a-244b may follow similar paths described above. FIGURE 2D illustrates an energy band diagram 260 for the same type of solar cell 100 as in FIGURE 2C, except the solar cell associated with FIGURE 2D includes a PEDOT buffer layer 122.

Although FIGURES 2A through 2D illustrate example energy band diagrams of a solar cell having tandem organic and inorganic structures, various changes may be made to FIGURES 2A through 2D. For example, any other material(s) with suitable Fermi level(s) or other characteristics could also be used in the solar cell 100.

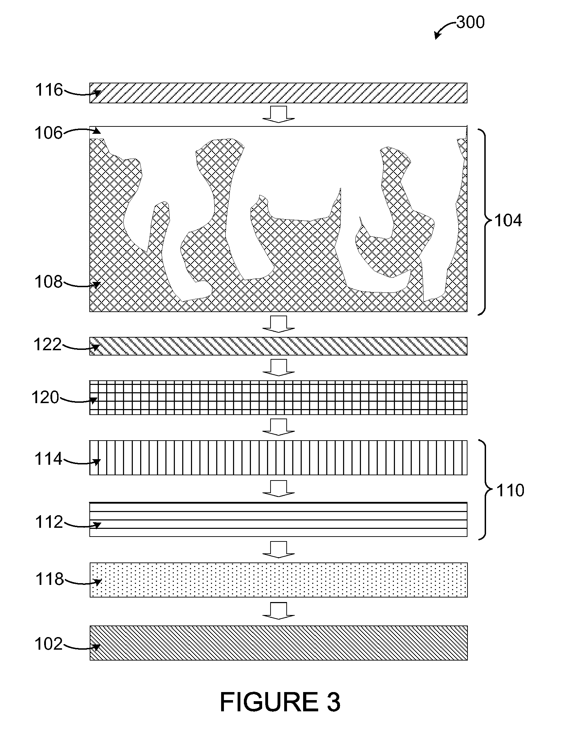

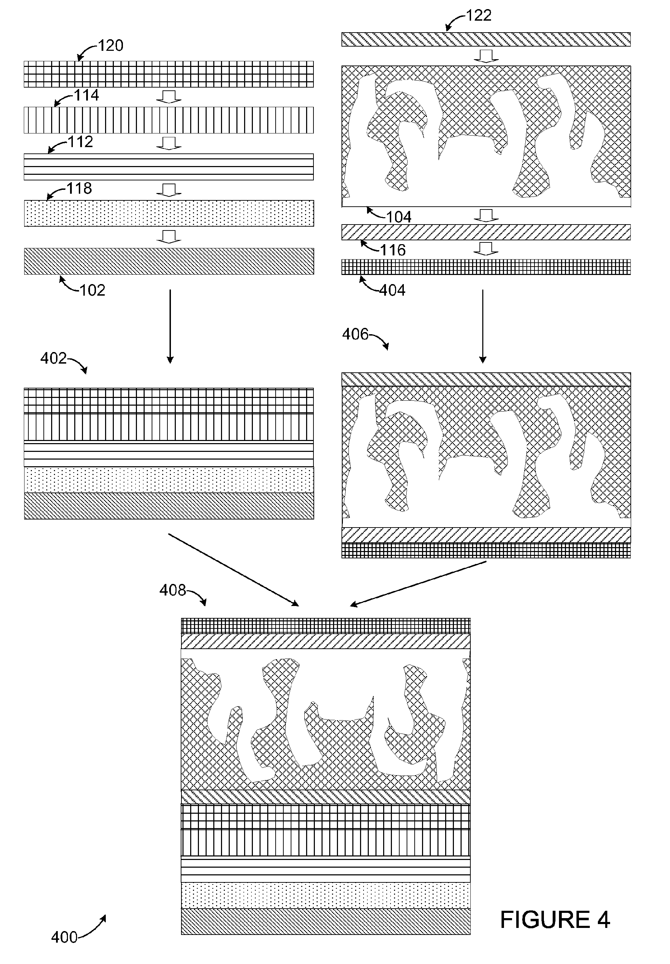

FIGURES 3 and 4 illustrate example techniques for forming a solar cell having tandem organic and inorganic structures according to this disclosure. The embodiments of the techniques shown in FIGURES 3 and 4 are for illustration only. Other techniques could be used without departing from the scope of this disclosure.

In FIGURE 3, a technique 300 forms the various layers and other structures in the solar cell 100 sequentially. In this example, a metallic foil or other material is used as the substrate 102. The electrode 118 is formed over the substrate 102, such as by depositing a thin layer of platinum. The platinum could be deposited using a vacuum deposition technique or by depositing platinum nanoparticles (such as by printing or spin coating) and then sintering the nanoparticles together using a mild annealing.

After that, the inorganic semiconductor layer 112 is formed, such as by depositing a layer of copper oxide. The copper oxide could be deposited by growing or by depositing copper oxide nanoparticles (such as by printing or spin coating) and then sintering the nanoparticles together using a mild annealing.

The inorganic semiconductor layer 114 is then formed, such as by depositing a layer of zinc oxide, titanium oxide, or tin oxide. The inorganic semiconductor layer 114 could be formed by growing (such as by solution using a hydrothermal technique), sputtering, or depositing nanoparticles (such as by printing or spin coating) and then sintering the nanoparticles together using a mild annealing. The inorganic semiconductor layer 120 is formed over the inorganic heterojunction 110, such as by sputtering or by sintering nanoparticles deposited via printing or spin coating. Optionally, the buffer layer 122 can be formed over the inorganic semiconductor layer 120, such as by spin casting or printing a PEDOT layer.

The organic heterojunction 104 is then formed by depositing the organic materials 106-108. For example, a blend of the organic materials 106-108 could be deposited by spin casting or printing. The electrode 116 is then formed, such as forming a ZnO:Al layer by sputtered or by depositing nanoparticles via printing or spin coating and sintering the nanoparticles via a mild annealing. This completes the formation of the solar cell structure shown in FIGURE 1.

In FIGURE 4, a technique 400 separately forms two portions of the solar cell 100 (possibly in parallel). In this example, a metallic foil or other material is used as the substrate 102. The electrode 118 is formed over the substrate 102, and the inorganic semiconductor layer 112 and the inorganic semiconductor layer 114 are formed over the electrode 118. After that, the inorganic semiconductor layer 120 is formed over the inorganic heterojunction 110. These components could be formed in the same or similar manner discussed above. This leads to the creation of a first intermediate structure 402.

A second intermediate structure can be formed at the same time or at a different time. Here, the electrode 116 is formed on a transparent or other substrate 404. The substrate 404 could represent plastic, glass, or other suitable material(s). The organic heterojunction 104 is formed over the electrode 116, and the buffer layer 122 can optionally be formed over the organic heterojunction 104. Again, these components could be formed in the same or similar manner discussed above. This forms a second intermediate structure 406.

At this point, the two intermediate structures 402 and 406 can be combined to form the solar cell 100. The intermediate structures 402 and 406 can be combined in any suitable manner, such as by using a flip-chip or roll-to-roll technique. This produces a final structure 408, which represents the solar cell 100 with the additional substrate 404. The substrate 404 could be removed or could form part of the finishes solar cell.

Although FIGURES 3 and 4 illustrate example techniques for forming a solar cell having tandem organic and inorganic structures, various changes may be made to FIGURES 3 and 4. For example, the operations or steps in each technique could have any suitable order, and various operations or steps could overlap, occur in parallel, or occur in a different order.

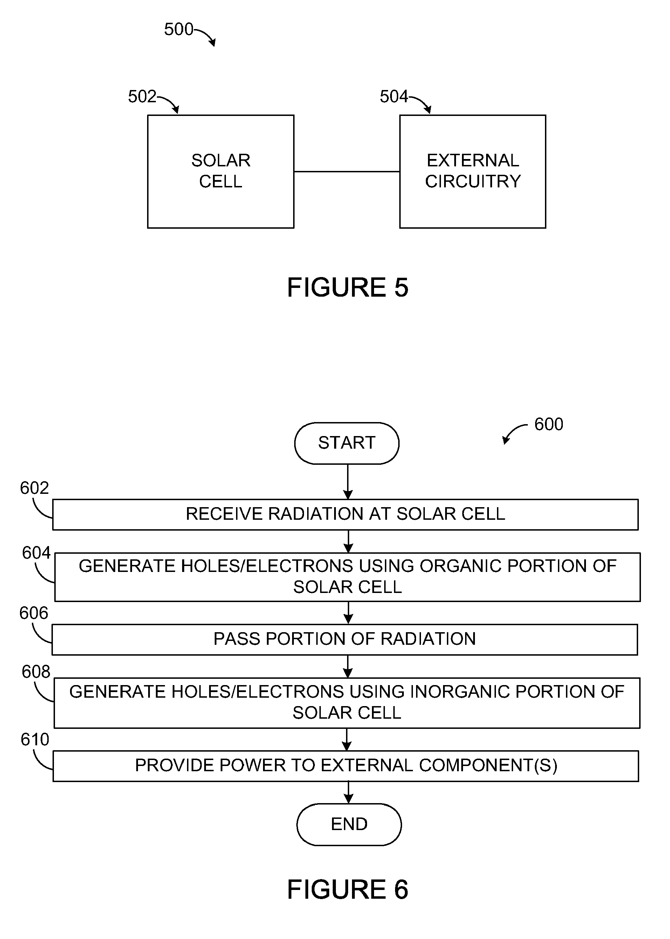

FIGURE 5 illustrates an example circuit 500 containing a solar cell having tandem organic and inorganic structures according to this disclosure. The circuit 500 shown in FIGURE 5 is for illustration only. Other circuits could use the solar cell 100 described above without departing from the scope of this disclosure.

In this example, a solar cell 502 is coupled to external circuitry 504. The solar cell 502 could represent any suitable solar cell having tandem organic and inorganic structures. The solar cell 502 could, for example, represent the solar cell 100 described above.

The external circuitry 504 represents any suitable circuitry for using power provided by the solar cell 502. For example, the external circuitry 504 could represent circuitry that performs monitoring or reporting functions in a wireless asset tag. The external circuitry 504 could also represent circuitry that performs monitoring or control functions in an industrial processing environment. The external circuitry 504 could further represent circuitry that uses the power from the solar cell 502 to recharge a battery or other power source. The external circuitry 504 could perform any other or additional functionality according to particular needs. At least part of the power used by the external circuitry 504 may be provided by the solar cell 502.

Although FIGURE 5 illustrates an example circuit 500 containing a solar cell having tandem organic and inorganic structures, various changes may be made to FIGURE 5. For example, the circuit 500 could include any number of solar cells 502 and external circuitry 504. Also, the solar cell 100 described above could be used in any other suitable manner.

FIGURE 6 illustrates an example method 600 for using a solar cell having tandem organic and inorganic structures according to this disclosure. The method 600 shown in FIGURE 6 is for illustration only. Solar cells having tandem organic and inorganic structures could be used in any other suitable manner without departing from the scope of this disclosure.

Radiation is received at a solar cell at step 602. This could include, for example, the solar cell 100 receiving solar radiation. This may also include the electrode 116 allowing visible light to pass through the electrode 116 while blocking UV radiation.

Holes and electrons are generated using an organic portion of the solar cell at step 604. This could include, for example, the organic heterojunction 104 generating electrons that are collected by the electrode 116. This could also include the organic heterojunction 104 generating holes that are collected by the inorganic semiconductor layer 120.

A portion of the radiation is passed through the organic portion of the solar cell at step 606. This could include, for example, photons of lower energy passing through the organic heterojunction 104.

Holes and electrons are generated using an inorganic portion of the solar cell at step 608. This could include, for example, the inorganic heterojunction 110 generating holes that are collected by the electrode 118. This could also include the inorganic heterojunction 110 generating electrons that recombine with holes collected by the inorganic semiconductor layer 120.

In this way, power can be provided to one or more external components at step 610. The electrons collected by the electrode 116 and the holes collected by the electrode 118 could, for example, be used to provide current to external circuitry, such as for use or storage.

Although FIGURE 6 illustrates an example method 600 for using a solar cell having tandem organic and inorganic structures, various changes may be made to FIGURE 6. For example, while shown as a series of steps, various steps in FIGURE 6 could overlap, occur in parallel, occur in a different order, or occur multiple times.

It may be advantageous to set forth definitions of certain words and phrases used throughout this patent document. The term "couple" and its derivatives refer to any direct or indirect communication between two or more elements, whether or not those elements are in physical contact with one another. The terms "include" and "comprise," as well as derivatives thereof, mean inclusion without limitation. The term "or" is inclusive, meaning and/or. Terms such as "over" and "under" may refer to relative positions in the figures and do not denote required orientations during manufacturing or use. Terms such as "higher" and "lower" denote relative values and are not meant to imply specific values or ranges of values. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like.

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A solar cell (100) comprising:
an organic heterojunction (104) including at least one donor material (106) and at least one acceptor material (108); and
an inorganic heterojunction (110) including multiple inorganic semiconductor materials (112-114).

2. The solar cell of Claim 1, wherein:
the organic heterojunction and the inorganic heterojunction absorb light in different portions of a solar spectrum;
the organic heterojunction absorbs higher-energy photons; and
the inorganic heterojunction absorbs lower-energy photons.

3. The solar cell of Claim 2, wherein the inorganic heterojunction comprises:
a p-type inorganic semiconductor material having a bandgap between one and two electron-volts; and
an n-type inorganic semiconductor material having a bandgap greater than three electron-volts.

4. The solar cell of Claim 1, further comprising:
an inorganic semiconductor layer (120) between the organic heterojunction and the inorganic heterojunction, the inorganic semiconductor layer configured to collect holes generated by the organic heterojunction; and
a buffer layer (122) between the organic heterojunction and the inorganic semiconductor layer, wherein the buffer layer improves hole injection onto the inorganic semiconductor layer.

5. The solar cell of Claim 4, wherein the inorganic semiconductor layer is further configured to block electrons generated by the organic heterojunction from reaching the inorganic heterojunction.

6. A system (500) comprising a solar cell (502) and circuitry (504) configured to receive power from the solar cell, the solar cell comprising:
an organic heterojunction (104) including at least one donor material (106) and at least one acceptor material (108); and
an inorganic heterojunction (110) including multiple inorganic semiconductor materials (112-114).

7. The system of Claim 6, wherein:
the organic heterojunction and the inorganic heterojunction absorb light in different portions of a solar spectrum;
the organic heterojunction absorbs higher-energy photons; and
the inorganic heterojunction absorbs lower-energy photons.

8. The system of Claim 6, wherein the solar cell further comprises:
an inorganic semiconductor layer (120) between the organic heterojunction and the inorganic heterojunction, the inorganic semiconductor layer configured to collect holes generated by the organic heterojunction; and
a buffer layer (122) between the organic heterojunction and the inorganic semiconductor layer, wherein the buffer layer improves hole injection onto the inorganic semiconductor layer.

9. The system of Claim 8, wherein:
at least some of the holes collected by the inorganic semiconductor layer recombine with electrons generated by the inorganic heterojunction; and
the inorganic semiconductor layer is further configured to block electrons generated by the organic heterojunction from reaching the inorganic heterojunction.

10. A method comprising:
receiving (602) radiation at a solar cell (100);
generating (604) electrons and holes using an organic heterojunction structure (104) in the solar cell, the organic heterojunction structure having at least one donor material (106) and at least one acceptor material (108);
generating (608) electrons and holes using an inorganic heterojunction structure (110) in the solar cell, the inorganic heterojunction structure having multiple inorganic semiconductor materials (112-114);
collecting at least some of the electrons at a first electrode (116); and
collecting at least some of the holes at a second electrode (118).
